# EUROPEAN PATENT APPLICATION

(11) **EP 4 202 751 A1**
(43) Date of publication of application: **28.06.2023**
(21) Application number: 22212268.1
(22) Date of filing: 08.12.2022
(51) Int. Cl.: G06F 30/12, G06F 30/17, G06F 30/20

(54) **LIST GENERATING APPARATUS**

(30) Priority: 22.12.2021 JP 2021207791
(71) Applicant: Subaru Corporation, Tokyo 150-8554 (JP)
(72) Inventor: TANAKA, Yuki, Tokyo, 150-8554 (JP); KOBAYASHI, Toshimasa, Tokyo, 150-8554 (JP)
(74) Representative: Vossius & Partner Patentanwälte Rechtsanwälte mbB

(57) **Abstract**

A list generating apparatus (1) includes a tree structure analyzer (21) and a list generator (23). The tree structure analyzer (21) is configured to make an analysis of a hierarchical tree structure (31) included in three-dimensional drawing data (10). The list generator (23) is configured to generate an inspection item list (13) on the basis of information obtained by the analysis of the hierarchical tree structure (31).

## Description

### BACKGROUND

### Technical Field

The disclosure relates to a list generating apparatus.

### Related Art

Apparatuses have been proposed which are configured to automatically generate contents of inspection standards and an inspection drawing corresponding to a design drawing when the design drawing is newly created or changed (see, e.g., Japanese Unexamined Patent Application Publication No. 2003-295934).

### SUMMARY

An aspect of the disclosure provides a list generating apparatus that includes a tree structure analyzer and a list generator. The tree structure analyzer is configured to make an analysis of a hierarchical tree structure included in three-dimensional drawing data. The list generator is configured to generate an inspection item list on a basis of information obtained by the analysis of the hierarchical tree structure.

### BRIEF DESCRIPTION OF THE DRAWINGS

FIG. 1 is a block diagram illustrating a configuration of a list generating apparatus;
FIG. 2 is a diagram illustrating data stored in a storage device;
FIG. 3 is a diagram illustrating functional blocks of a CPU;
FIG. 4 is a diagram illustrating an example of three-dimensional drawing data;
FIG. 5 is a diagram illustrating a result of analyzing a tree structure;
FIG. 6 is a diagram illustrating a component part list;
FIG. 7 is a diagram illustrating a special process list;
FIG. 8 is a diagram illustrating standard data of "spec#1"; and
FIG. 9 is a diagram illustrating a design characteristics list.

### DETAILED DESCRIPTION

In drawing data, such as three-dimensional drawing data, requirements for an article are often indicated by text. An inspection item list is a list for checking whether an article produced in accordance with drawing data meets requirements indicated in the drawing data. The inspection item list has been manually generated on the basis of text in the drawing data. This has taken a significant amount of time and has affected work efficiency.

It is desirable to provide a list generating apparatus that can improve work efficiency.

Preferred embodiments of the disclosure will now be described in detail with reference to the accompanying drawings. Dimensions, materials, and numerical values presented in the embodiments are merely examples for easy understanding of the disclosure, and are not intended to limit the scope of the disclosure unless otherwise stated. In the present specification and the drawings, elements that have substantially the same functions or configurations are denoted by the same reference numerals to avoid duplicate explanation. Elements not directly related to the disclosure are not presented in the drawings.

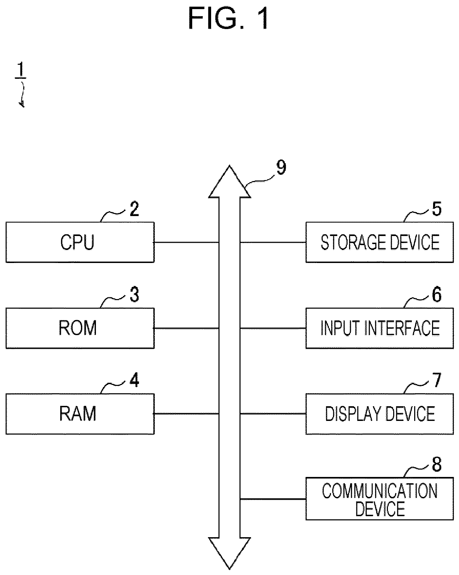

FIG. 1 is a block diagram illustrating a configuration of a list generating apparatus 1. The list generating apparatus 1 generates an inspection item list, such as a first article inspection (FAI) item list, on the basis of drawing data. The inspection item list is generated to check whether an article produced in accordance with the drawing data meets requirements indicated in the drawing data.

As illustrated in FIG. 1, the list generating apparatus 1 is a computer that includes a central processing unit (CPU) 2, a read only-memory (ROM) 3, and a random-access memory (RAM) 4. The list generating apparatus 1 includes a storage device 5, an input interface (input I/O) 6, a display device 7, and a communication device 8.

The CPU 2, the ROM 3, the RAM 4, the storage device 5, the input interface 6, the display device 7, and the communication device 8 in the list generating apparatus 1 are coupled to one another by a bus 9.

The CPU 2 expands, in the RAM 4, a program stored in the ROM 3 or the storage device 5, and executes the expanded program to control the overall operation of the list generating apparatus 1.

The storage device 5 includes, for example, a hard disk drive (HDD) and a solid state drive (SSD). The storage device 5 stores programs (software programs) executable by the CPU 2 and many pieces of data. Details of the data stored in the storage device 5 will be described later below.

The input interface (input I/O) 6 includes, for example, a mouse, a keyboard, and a touch panel and accepts a user's input operation. The input interface 6 outputs information corresponding to the user's input operation to the CPU 2.

The display device 7 is, for example, a liquid crystal display or an organic electroluminescence (EL) display. The display device 7 displays an image in accordance with the control by the CPU 2.

The communication device 8 is coupled to, and communicates with, an external device through a wired or wireless network in accordance with the control by the CPU 2.

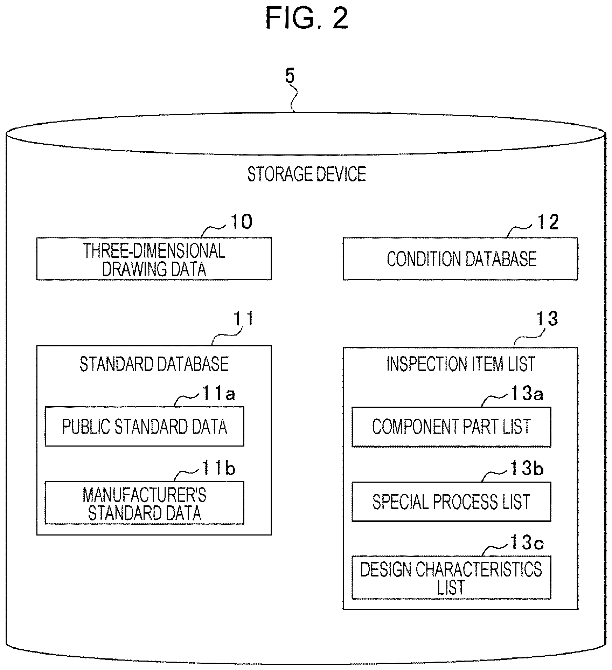

FIG. 2 is a diagram illustrating data stored in the storage device 5. As illustrated in FIG. 2, the storage device 5 stores three-dimensional drawing data 10, a standard database 11, a condition database 12, and an inspection item list 13. On the basis of the three-dimensional drawing data 10 stored in the storage device 5, the list generating apparatus 1 generates the inspection item list 13 with reference to the standard database 11 and the condition database 12. The inspection item list 13 is one that is eventually generated by the list generating apparatus 1 and is not initially present in the storage device 5.

The list generating apparatus 1 generates the inspection item list 13 on the basis of the three-dimensional drawing data 10. As described in detail later below, the three-dimensional drawing data 10 is data generated by three-dimensional computer aided design (CAD) software. The three-dimensional drawing data 10 includes a three-dimensional model and a hierarchical tree structure.

The standard database 11 includes standard data which is data of known standards, such as standards of each country and standards of private companies, organized into a database. The standard database 11 includes, for example, public standard data (e.g., American Society of Mechanical Engineers (ASME) standard data) 11a which is data of publicly-known standards organized into a database, and manufacturer's standard data 11b which is data of manufacturer-specific standards or specifications organized into a database.

The condition database 12 stores condition data (keywords) used in generating the inspection item list 13.

The inspection item list 13 includes a component part list 13a (Form1), a special process list 13b (Form2), and a design characteristics list 13c (Form3). As described in detail later below, the component part list 13a is a list of component parts described in the three-dimensional drawing data 10, the special process list 13b is a list of special processes described in the three-dimensional drawing data 10, and the design characteristics list 13c is a list of design characteristics (requirements for an article) described in the three-dimensional drawing data 10. The term "special process" refers to, for example, a process which is to be validated in advance or regularly, because conditions of how the process is managed have significant impact on quality and it is difficult to perform quality checking, such as checking of strength and corrosion resistance, in inspections after the process.

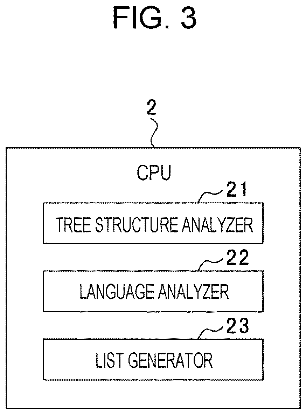

FIG. 3 is a diagram illustrating functional blocks of the CPU 2. The CPU 2 expands, in the RAM 4, a program stored in the ROM 3 or the storage device 5 and executes the expanded program to function as a tree structure analyzer 21, a language analyzer 22, or a list generator 23. Some of these functional units may not function, depending on the three-dimensional drawing data 10 received.

### <Process of generating inspection item list 13 from three-dimensional drawing data 10>

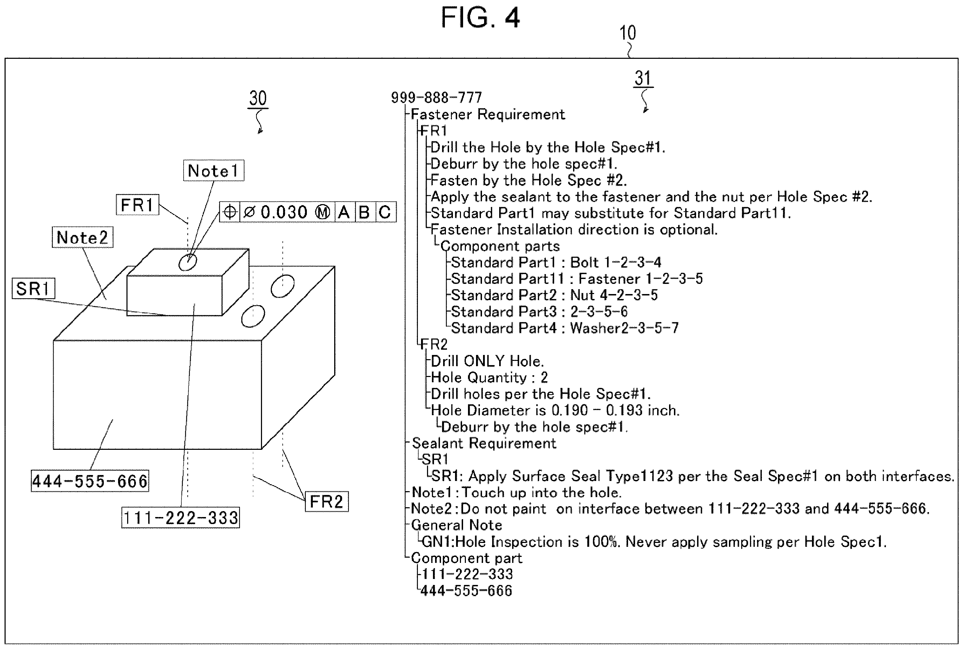

FIG. 4 is a diagram illustrating the three-dimensional drawing data 10. The three-dimensional drawing data 10 illustrated in FIG. 4 is one that is read by the three-dimensional CAD software and displayed in the display device 7.

As illustrated in FIG. 4, the three-dimensional drawing data 10 includes a three-dimensional model 30 and a hierarchical tree structure 31. In the three-dimensional model 30, for example, the shapes, positions, and orientations of an assembly and parts are indicated by lines, dots, and text. In the tree structure 31, for example, the assembly, parts, and drawing requirement items (e.g., processing condition items, fastening condition items) included in the three-dimensional model 30 are managed at different hierarchical levels.

For example, the tree structure 31 provides a file name of the three-dimensional drawing data 10 at the top hierarchical level. At the second and following hierarchical levels of the tree structure 31, the assembly, parts, and drawing requirement items (e.g., processing condition items, fastening condition items) included in the three-dimensional model 30 are listed at one or more levels. Each item of the tree structure 31 contains text.

In the example illustrated in FIG. 4, for example, the items "Fastener Requirement" and "Sealant Requirement" are listed at a hierarchical level (level 1) lower than the item "999-888-777" (level 0), the items "FR1" and "FR2" are listed at a hierarchical level (level 2) lower than the item "Fastener Requirement", and the items "Drill the Hole by Hole Spec#1." and "Deburr by the hole spec#1." are listed at a hierarchical level (level 3) lower than the item "FR1".

The item "Drill the Hole by Hole Spec#1." is a drawing requirement item indicated by text. The item "Drill the Hole by Hole Spec#1." states that drilling is to be performed in accordance with the manufacturer's standard "Spec#1". The item "Deburr by the hole spec#1." is a drawing requirement item indicated by text. The item "Deburr by the hole spec#1." states that deburring is to be performed in accordance with the manufacturer's standard "spec#1".

As described above, the three-dimensional drawing data 10 includes model-based requirements presented by the three-dimensional model 30 and various text-based requirements presented by the tree structure 31. For example, the three-dimensional drawing data 10 for an aircraft may include 50 thousands or more drawing requirements (model-based requirements and text-based requirements).

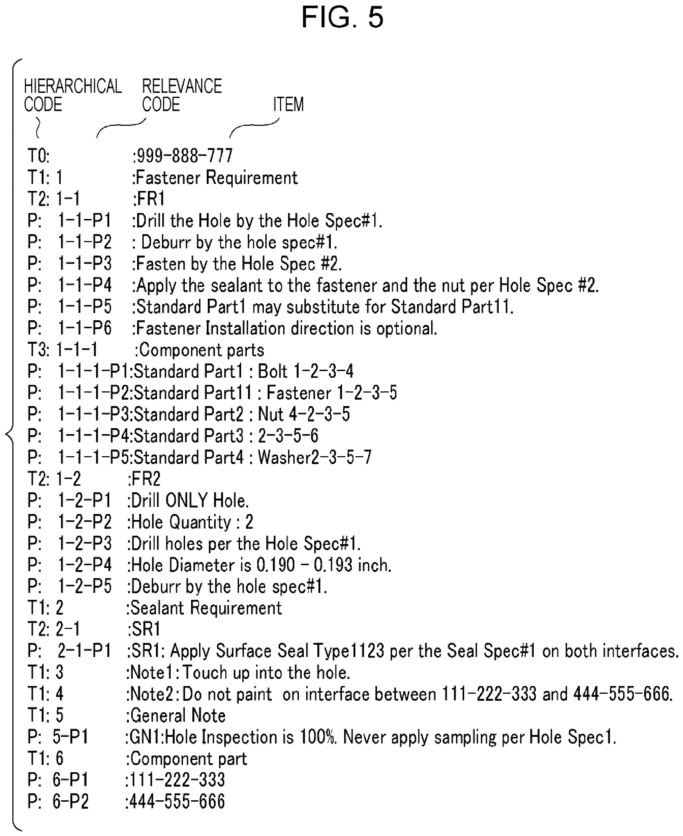

FIG. 5 is a diagram illustrating a result of analyzing the tree structure 31. The tree structure analyzer 21 analyzes the tree structure 31 in the three-dimensional drawing data 10. For example, as illustrated in FIG. 5, the tree structure analyzer 21 assigns a hierarchical code to each item of the tree structure 31. The hierarchical code represents a hierarchical level to which the corresponding item belongs. In this example, the tree structure analyzer 21 assigns the hierarchical codes "T0", "T1", "T2", and so on in such a way that the numerical value of the code increases as the hierarchical level of the item goes down from the top. For example, the tree structure analyzer 21 assigns the hierarchical code "T0" to the item at the top hierarchical level (level 0), assigns the hierarchical code "T1" to the items at the next hierarchical level (level 1), and assigns the hierarchical code "T2" to the items at the next hierarchical level (level 2). The tree structure analyzer 21 also assigns the hierarchical code "P" to the items at the lowest hierarchical level.

The tree structure analyzer 21 also assigns a relevance code to each item of the tree structure 31. The relevance code represents a relevance of the corresponding item to other items. For example, if there are multiple items with the hierarchical code "T1", the tree structure analyzer 21 assigns the relevance codes "1", "2", and so on to the items in order from the top downward. Also, if there are multiple items with the hierarchical code "T2" to which the relevance code "1" is added, the tree structure analyzer 21 assigns the relevance codes "1-1", "1-2", and so on to the items in order from the top downward. The relevance code "1-1" indicates that the corresponding item is at a hierarchical level one level lower than the item with the relevance code "1". Note that no relevance code is added to the hierarchical code "T0". This is because the item at the top hierarchical level is the file name of the three-dimensional drawing data 10, and has no relevance to other items.

As described above, each time the hierarchical level goes down, a relevance code that includes a relevance code of an item at a hierarchical level one level higher is assigned by the tree structure analyzer 21 to the item of interest. Note that the relevance codes, such as "P1" and "P2", each including the letter "P" as well as a number, are assigned to the items at the lowest hierarchical level.

For example, the tree structure analyzer 21 assigns the relevance code "1" to the item "Fastener Requirement", assigns the relevance code "1-1" to the item "FR1" at a hierarchical level lower than the item "Fastener Requirement", and assigns the relevance code "1-1-P1" to the item "Drill the Hole by Hole spec#1." at a hierarchical level lower than the item "FR1" (or at the lowest hierarchical level).

By thus assigning the hierarchical codes and the relevance codes, the tree structure analyzer 21 facilitates understanding of relevance between items in the tree structure 31. Also, by adding "P" to the relevance code of each item at the lowest hierarchical level, the tree structure analyzer 21 makes it easier to understand that the item at the lowest hierarchical level is a component part, a special process, or a design characteristic of an item at a higher hierarchical level.

### (Component part list generation process)

When generating the component part list 13a on the basis of the three-dimensional drawing data 10, the language analyzer 22 reads, from the condition database 12, component part keywords for generating the component part list 13a. As a component part keyword for generating the component part list 13a, for example, a character string "comp" is described in the condition database 12. The character string "comp" is part of a character string "component" (meaning a structural element). The character string "comp" is used to search for the character string "component".

The language analyzer 22 then extracts an item containing the character string "comp", which is a component part keyword. The language analyzer 22 extracts the item regardless of whether the character string contained therein is an uppercase, lowercase, one-byte, or two-byte character string.

In the example illustrated in FIG. 5, the items containing the character string "comp" are the item "component parts" with the relevance code "1-1-1" and the item "component part" with the relevance code "6". Accordingly, the language analyzer 22 extracts the item "component parts" with the relevance code "1-1-1" and the item "component part" with the relevance code "6".

Next, the language analyzer 22 refers to the relevance code, selects an item at a hierarchical level higher than the extracted item as a target, and determines whether the selected item contains a trigger keyword (described in detail below).

Here, the trigger keyword is a character string representing a special process or a design characteristic, or is part of a character string representing a special process or a design characteristic. Therefore, if the selected item contains a trigger keyword, the language analyzer 22 determines that an item with a relevance code including the relevance code of the selected item is a part used in a special process or a part presented in a design characteristic, and is not a component part included in the three-dimensional drawing data 10.

If an item at a hierarchical level higher than the selected item does not contain a trigger keyword, the language analyzer 22 determines that an item at a hierarchical level lower than the extracted item is a component part, and extracts the item at the hierarchical level lower than the extracted item as a component part. In the example illustrated in FIG. 5, the item "Fastener Requirement" (with the relevance code "1") at a hierarchical level higher than the item "component parts" with the relevance code "1-1-1" contains a trigger keyword "fas" (described below). Therefore, the language analyzer 22 determines that the item "component parts" is not an item representing a component part. On the other hand, since there is no hierarchical level above the item "component part" with the relevance code "6", the item "111-222-333" and the item "444-555-666" below the item "component part" with the relevance code "6" are selected as items representing component parts.

The list generator 23 generates the component part list 13a (Form1) that lists the items extracted by the language analyzer 22.

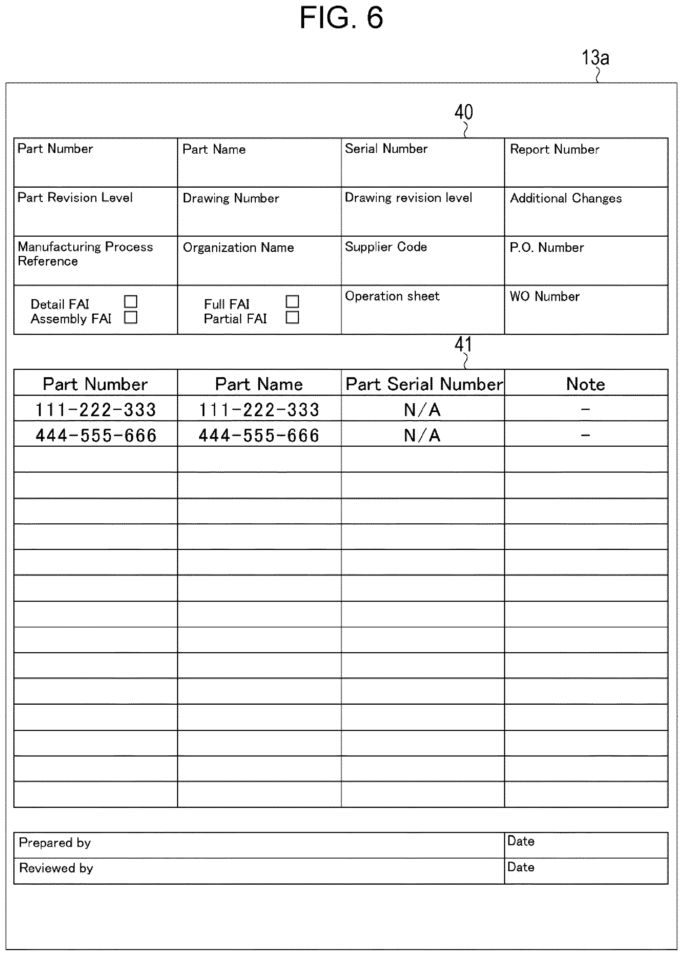

FIG. 6 is a diagram illustrating the component part list 13a. As illustrated in FIG. 6, the component part list 13a includes drawing information 40 and component part information 41. The drawing information 40 includes information, such as a part number, a part name, a serial number, and a drawing number. The component part information 41 includes a list of all component parts (except standard parts) described in the three-dimensional drawing data 10.

The contents of the drawing information 40 may be entered by extracting items from the three-dimensional drawing data 10, or may be entered by an operator or by other methods.

To generate the component part list 13a (Form1), the list generator 23 lists the text of items extracted by the language analyzer 22, in sequence, in the "Part Number" column of the component part information 41.

### (Special process list generation process)

To generate the special process list 13b on the basis of the three-dimensional drawing data 10, the language analyzer 22 reads special process keywords from the condition database 12. The special process keywords represent specifications of the special processes defined by the public standard data 11a and the manufacturer's standard data 11b, which are stored in the standard database 11.

Assume that the public standard data 11a or the manufacturer's standard data 11b defines, for example, "spec#1" and "spec#2" as the specifications of the special processes. In this case, the character strings "spec#1" and "spec#2" are described in the condition database 12 as the special process keywords. The character string "spec#1" represents the specifications for drilling a hole, and the character string "spec#2" represents the specifications for fastening.

Then, from the text contained in items in the tree structure 31, the language analyzer 22 extracts character strings that match the read special process keywords. For every special process keyword read, the language analyzer 22 extracts a character string that matches.

In the example illustrated in FIG. 5, the character string "spec#1" and the character string "spec#2" are extracted. The character string "spec#1" is contained in multiple items, but is to be simply extracted once.

The list generator 23 generates the special process list 13b (Form2) which is a list of the character strings extracted by the language analyzer 22, that is, a list of the special process keywords.

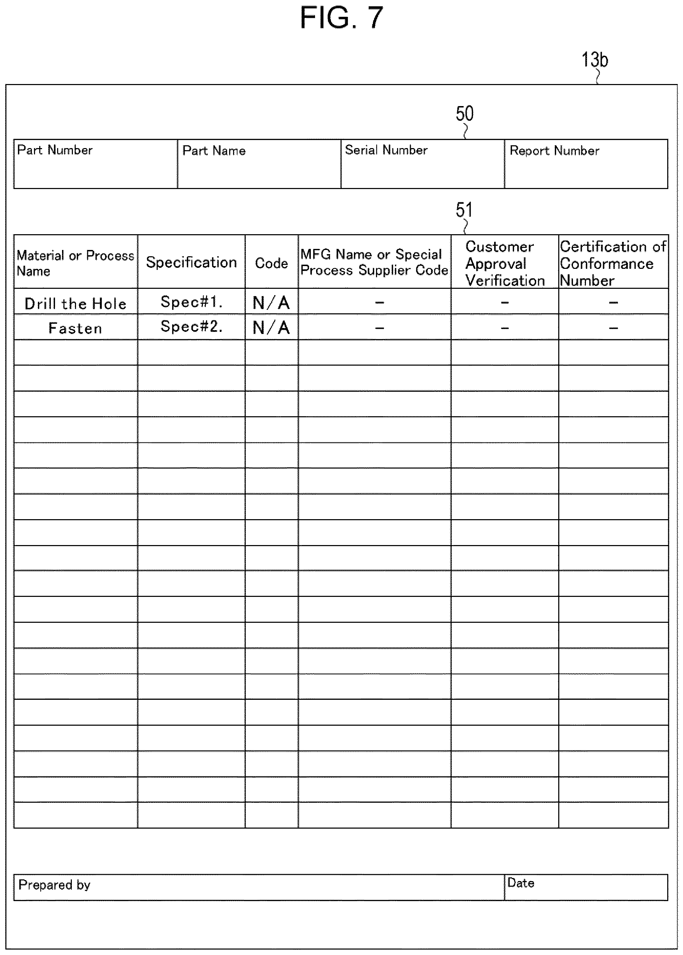

FIG. 7 is a diagram illustrating the special process list 13b. As illustrated in FIG. 7, the special process list 13b includes drawing information 50 and special process information 51. The drawing information 50 includes information, such as a part number, a part name, and a serial number. The special process information 51 includes a list of all special processes described in the three-dimensional drawing data 10.

The contents of the drawing information 50 may be entered by extracting items from the three-dimensional drawing data 10, or may be entered by an operator or by other methods.

To generate the special process list 13b (Form2), the list generator 23 lists the character strings extracted by the language analyzer 22 or the special process keywords, in sequence, in the "Specification" column of the special process information 51, and also lists process names that are set for the respective special process keywords, in sequence, in the "Material or Process Name" column of the special process information 51.

### (Design characteristics list generation process)

To generate the design characteristics list 13c on the basis of the three-dimensional drawing data 10, the language analyzer 22 reads, from the condition database 12, main keywords for generating the design characteristics list 13c. As a main keyword for generating the design characteristics list 13c, for example, a character string "hole" is described in the condition database 12.

Then, from the text contained in items in the tree structure 31, the language analyzer 22 extracts an item that contains the character string "hole", which is a main keyword.

In the example illustrated in FIG. 5, the language analyzer 22 extracts, for example, the item "Drill the Hole by Hole Spec#1." with the relevance code "1-1-P1" as an item containing the character string "hole", which is a main keyword.

Then, if the item containing the character string "hole", which is a main keyword, contains a trigger keyword, the language analyzer 22 determines whether the item contains a related keyword "part", "comp", "fas", or "nut" representing a part (or component), a related keyword "per" or "by" representing a preposition for the specification, or a related keyword "dia" representing a diameter. Here, the language analyzer 22 determines that the item "Drill the Hole by Hole Spec#1." contains the related keyword "by" representing a preposition for the specification.

If determining that the item contains a related keyword representing a preposition for the specification, the language analyzer 22 extracts, within a range based on a relevance code (e.g., within a range including the relevance code "1-1"), an item that contains a keyword "part", "comp", "bolt", or "nut" representing a standard part. In the case of the item "Drill the Hole by Hole Spec#1.", for example, the item "Standard Part1: Bolt 1-2-3-4" with the relevance code "1-1-1-P1" is extracted. The relevance code of the item "Standard Part1: Bolt 1-2-3-4" contains "1-1" in common with the item "Drill the Hole by Hole Spec#1.".

The language analyzer 22 also extracts the character string "spec#1" representing a special process keyword in the item "Drill the Hole by Hole Spec#1.". Then, the language analyzer 22 reads standard data corresponding to "spec#1" from the standard database 11.

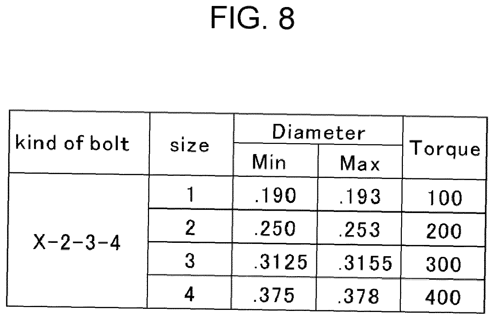

FIG. 8 is a diagram illustrating standard data of "spec#1". As illustrated in FIG. 8, size, diameter, and torque are associated with a bolt standard "X-2-3-4" in "spec#1". Note that X at the left end of the bolt standard "X-2-3-4" is any number, which represents a size.

The language analyzer 22 searches the standard data on the basis of the character string "2-3-4" in the extracted item "Standard Part1: Bolt 1-2-3-4" and extracts, on the basis of the character string "1", the minimum diameter and the maximum diameter as design characteristics. For example, the language analyzer 22 refers to the diameter corresponding to the size "1" of "kind of bolt X-2-3-4" in the standard data of "spec#1", and extracts the minimum diameter ".190" and the maximum diameter ".193" as design characteristics.

The list generator 23 generates the design characteristics list 13c (Form3) that lists the design characteristics extracted by the language analyzer 22.

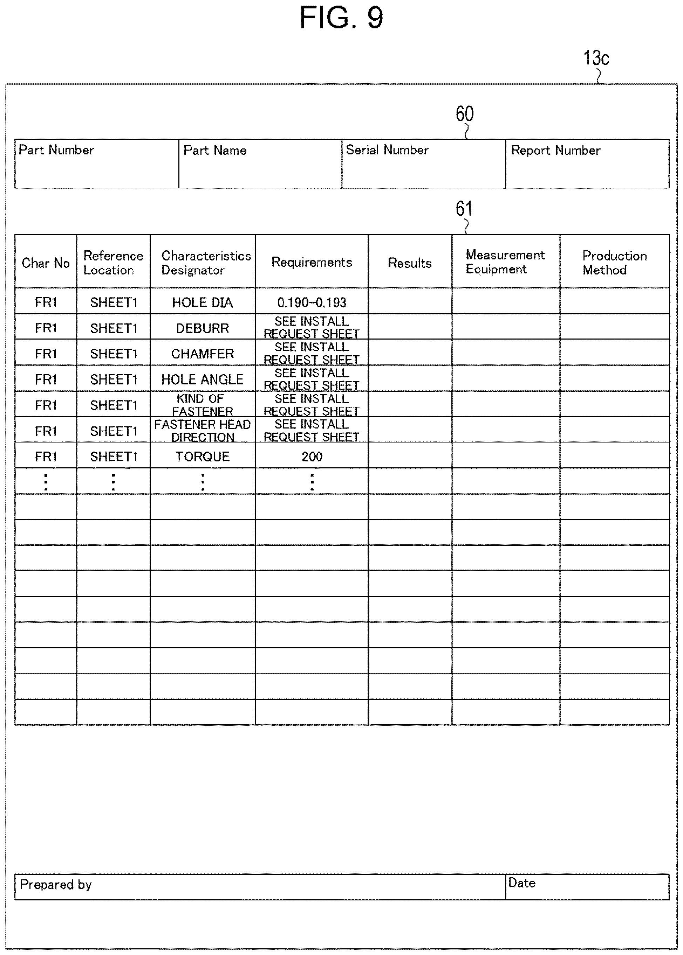

FIG. 9 is a diagram illustrating the design characteristics list 13c. As illustrated in FIG. 9, the design characteristics list 13c includes drawing information 60 and design characteristics information 61. The drawing information 60 includes information, such as a part number, a part name, and a serial number. The design characteristics information 61 includes a list of all design characteristics described in the three-dimensional drawing data 10.

The contents of the drawing information 60 may be entered by extracting items from the three-dimensional drawing data 10, or may be entered by an operator or by other methods.

To generate the design characteristics list 13c (Form3), the list generator 23 lists the design characteristics extracted by the language analyzer 22, in sequence, in the design characteristics information 61. For example, the list generator 23 lists the character strings extracted by the language analyzer 22, or the design characteristics, in the "Requirements" column of the design characteristics information 61, lists the contents of characteristics set for the respective special process keywords in the "Characteristics Designator" column of the design characteristics information 61, and lists characteristics names in the "Char No" column of the design characteristics information 61. As indicated by "SEE INSTALL REQUEST SHEET" in the "Requirements" column of the design characteristics information 61, the design characteristics may be listed on another sheet.

The list generating apparatus 1 can thus generate the inspection item list 13 from the three-dimensional drawing data 10.

As described above, the list generating apparatus 1 analyzes the tree structure 31 included in the three-dimensional drawing data 10 and generates an inspection item list on the basis of information obtained by analyzing the tree structure 31. The list generating apparatus 1 can thus generate the inspection item list 13 more quickly and accurately than when the inspection item list 13 is manually generated on the basis of the three-dimensional drawing data 10, so that improved work efficiency is achieved.

Although preferred embodiments of the disclosure have been described with reference to the accompanying drawings, the disclosure is not limited to the embodiments described above. A person skilled in the art can make various changes or modifications within the scope of the appended claims. It is to be understood that those changes or modifications are also within the technical scope of the disclosure.

The list generating apparatus 1 illustrated in FIG. 1 can be implemented by circuitry including at least one semiconductor integrated circuit such as at least one processor (e.g., a central processing unit (CPU)), at least one application specific integrated circuit (ASIC), and/or at least one field programmable gate array (FPGA). At least one processor can be configured, by reading instructions from at least one machine readable tangible medium, to perform all or a part of functions of the list generating apparatus 1 including the tree structure analyzer 21 and the list generator 23 illustrated in FIG. 3. Such a medium may take many forms, including, but not limited to, any type of magnetic medium such as a hard disk, any type of optical medium such as a CD and a DVD, any type of semiconductor memory (i.e., semiconductor circuit) such as a volatile memory and a non-volatile memory. The volatile memory may include a DRAM and a SRAM, and the non-volatile memory may include a ROM and a NVRAM. The ASIC is an integrated circuit (IC) customized to perform, and the FPGA is an integrated circuit designed to be configured after manufacturing in order to perform, all or a part of the functions of the modules illustrated in FIG. 3.

## Claims

1. A list generating apparatus comprising:
a tree structure analyzer configured to make an analysis of a hierarchical tree structure in three-dimensional drawing data; and
a list generator configured to generate an inspection item list based on information obtained by the analysis of the hierarchical tree structure.

2. The list generating apparatus according to Claim 1, wherein
the tree structure analyzer is configured to assign a relevance code to each of items of the tree structure, the relevance code indicating a relevance of each of the items with another item of the tree structure; and
the list generator is configured to generate the inspection item list on a basis of the relevance code.

3. The list generating apparatus according to Claim 2, wherein the tree structure analyzer is configured to assign, to each of the items of the tree structure, a hierarchical code indicating a hierarchical level, and assign the relevance code based on the hierarchical code.

4. The list generating apparatus according to any one of Claims 1 to Claim 3, wherein the list generator is configured to generate one or both of a component part list and a special process list, the component part list being a list of parts presented in the three-dimensional drawing data, the special process list being a list of special processes presented in the three-dimensional drawing data.

5. The list generating apparatus according to Claim 4, wherein the list generator is configured to generate the component part list and the special process list.
